# EUROPEAN PATENT APPLICATION

(11) **EP 3 226 418 A1**
(43) Date of publication of application: **04.10.2017**
(21) Application number: 17153242.7
(22) Date of filing: 26.01.2017
(51) Int. Cl.: H03K 19/177, B23K 10/00

(54) **WELDING-TYPE SYSTEM WITH FIELD PROGRAMMABLE HARDWARE**

(30) Priority: 29.03.2016 US 201615084051
(71) Applicant: Illinois Tool Works, Inc., Glenview, Illinois 60025 (US)
(72) Inventor: ULRICH, James F., Glenview, Illinois 60025 (US); BROWN, Brian, Glenview, Illinois 60025 (US); BOLLERMAN, Eric, Glenview, Illinois 60025 (US)
(74) Representative: Trinks, Ole

(57) **Abstract**

A welding-type control system including configurable hardware (16), a hardware configuration memory device (18) that configures the configurable hardware when loaded with configuration data, a processor (14), an input portal (20) via which the processor can receive a file with the configuration data, and a memory (15) with instructions that when executed by the processor (14) cause the processor to transfer the configuration data in the file to the memory device (18). A controlled system including such a welding-type control system includes a welding system, a cladding system or a plasma cutting system.

## Description

### BACKGROUND

The present disclosure generally relates to microcontroller devices with field programmable hardware used in welding-type systems. More particularly, the disclosure relates to mechanisms and operations for programming such hardware.

Programmable hardware as used herein to refers to logic effecting devices, the logic of which can be reconfigured. This contrasts with software or memory devices which simply store program instructions and the like which are loaded into temporary memory when invoked by the microcontroller or a microprocessor. In other words, in, e.g., a processor, the logic is fixed and only the inputs to it change, while for configurable hardware, the actual logic can be changed.

Programmable Array Logic (PAL) refers to a family of programmable logic device semiconductors used to implement logic functions in digital circuits introduced by Monolithic Memories, Inc. (MMI) in March 1978. PAL devices consisted of a small PROM (programmable read-only memory) core and additional output logic used to implement particular desired logic functions with few components. Using specialized machines, PAL devices were "field-programmable." PALs were available in several variants.

One-time programmable" (OTP) devices could not be updated and reused after initial programming. UV light erasable versions had a quartz window over the chip die and could be erased for re-use with an ultraviolet light source just like an erasable PROM (EPROM). Later versions were flash erasable devices. In many applications, electrically-erasable general array logic (GAL) devices are now deployed as pin-compatible direct replacements for one-time programmable PALs.

A field-programmable gate array (FPGA) is an integrated circuit designed to be configured by a customer or a designer after manufacturing - hence "field-programmable." The FPGA configuration is generally specified using a hardware description language (HDL), similar to that used for an application-specific integrated circuit (ASIC).

FPGAs contain an array of programmable logic blocks, and a hierarchy of reconfigurable interconnects that allow the blocks to be "wired together," like many logic gates that can be inter-wired in different configurations. Logic blocks can be configured to perform complex combinational functions, or merely simple logic gates like AND and XOR. In most FPGAs, logic blocks also include memory elements, which may be simple flip-flops or more complete blocks of memory.

Also, FPGAs can contain flash memory (described below) on the same chip as the configurable logic.

A complex programmable logic device (CPLD) is a programmable logic device with complexity between that of PALs and FPGAs, and architectural features of both. The main building block of the CPLD is a macrocell, which contains logic implementing disjunctive normal form expressions and more specialized logic operations.

A simple programmable logic device (SPLD) is a programmable logic device with complexity below that of a complex programmable logic device (CPLD). Simple programmable logic devices (SPLD) can be used in boards to replace 7400-series TTL components (AND, OR, and NOT gates). They typically comprise 4 to 22 fully connected macrocells. These macrocells typically consist of some combinatorial logic (such as AND OR gates) and a flip-flop. In other words, a small Boolean logic equation can be built within each macrocell. This equation will combine the state of some number of binary inputs into a binary output and, if necessary, store that output in the flip-flop until the next clock edge. Of course, the particulars of the available logic gates and flip-flops are specific to each manufacturer and product family. But the general idea is always the same.

A system on a chip or system on chip (SoC or SOC) is an integrated circuit (IC) that integrates all components of a computer or other electronic system into a single chip. It may contain digital, analog, mixed-signal, and often radiofrequency functions, including FPGAs or CPLDs-all on a single chip substrate.

The control board for welding-type systems such as a welder, cladding device, plasma cutting device, or induction heater can have both a microcontroller with configurable software and a field programmable gate array or other configurable hardware such as a complex programmable logic. While software upgrades for welding machines are commonly available, configurable hardware upgrades are not.

Miller Electric Manufacturing Co. provides a welding system called the PipeWorx system. The PipeWorx multi-process welding system is designed for use in pipe fabrication shops to provide ease-of-use and exceptional pipe-welding performance with quick, one-button changeover between processes.

The PipeWorx system uses a secure digital (SD) format flash memory card to update process software. Using the SD card, it is possible to update process code, user interface code, and motor drive code.

Configurable hardware, including that used in welding, cladding and plasma cutting systems, is typically assumed to be left unchanged after development. However, sometimes hardware changes are needed. Changes to configurable hardware typically involve changing entire circuit boards or using external programming adapters.

### SUMMARY

The present disclosure provides one or more inventions in which it is possible to update welding-type system configurable hardware in the field without using an external programmer unit or without changing entire circuit boards or using external programming adapters. Specifically, it is possible to update welding-type configurable hardware by simply uploading a file to a microcontroller based system via an input portal. Preferably, the file is loaded using a non-transitory computer readable storage medium, a serial or parallel interface, or a wireless communications system.

As used herein, a welding-type system means any of a welding system, a cladding system, a plasma cutting system or and induction heating system.

An input portal is any port or arrangement via which an electronic file can be received by the microcontroller. Non-limiting examples include memory card readers; serial or parallel interfaces such as network ports, e.g. Ethernet ports, and device to device ports, e.g., USB, Firewire, Lighting ports, IEEE 1394 ports and the like; and wireless communications systems/devices.

A non-transitory computer readable storage medium means and includes random access memory, read only memory, flash memory, portable memory devices such as secure digital (SD®) memory cards, compact flash digital cards, thumb drives, pen drives, microSD® cards, miniSD® cards, and the like, as well as recording medium such as magnetic or optical recording discs.

A wireless communications system can be any of a WiFi®, BlueTooth®, cellular, or infrared communications system, among others.

In an embodiment, a welding-type control system includes configurable hardware, a hardware configuration memory device that configures the configurable hardware when loaded with configuration data, a processor, an input portal via which the processor can receive a file with the configuration data, and a memory with instructions that when executed by the processor cause the processor to transfer the configuration data in the file to the memory device.

In an embodiment, the instructions cause the processor to validate the file by reading information in a header in the file and comparing the information to validating information.

In an embodiment, the instructions cause the processor to transfer the configuration data to the hardware configuration memory device.

In an embodiment, the instructions cause the processor to reverse the order of the bits in each byte of configuration data to be in reverse significant bit order prior to transfer of the configuration data to the hardware configuration memory device.

In an embodiment, the input portal is a card reader for a memory card.

In an embodiment, the configurable hardware is a field programmable gate array.

In an embodiment, the hardware configuration memory device comprises flash memory.

In an embodiment, the configurable hardware and the hardware configuration memory device are portions of a same chip.

In an embodiment, the input portal is a wireless communications unit.

In an embodiment, a controlled system including any of the embodiments above is a welding, cladding or plasma cutting system.

In an embodiment, a non-transitory computer readable medium includes program instructions that when executed by a processor, cause the processor to: (a) read a header in a raw programming data file to validate the raw programming data file; (b) extract raw programming data from the raw programming data file; and (c) transmit the raw programming data to a hardware configuration memory device.

In an embodiment, the program instructions, when executed by the processor, cause the processor to format each byte of the raw programming data prior to transmitting the raw programming data to the hardware configuration memory device by ordering the bits of the byte in reverse significant bit order.

In an embodiment, the program instructions, when executed by the processor, cause the processor to use a 256 byte transmit buffer to transmit 512 byte serial sectors of raw programming data in incremental blocks, taking into account an offset in the raw programming data in the raw programming data file caused by the presence of the header.

Additional features and advantages of exemplary embodiments will be set forth in the description which follows, and in part will be apparent from the description. The objectives and advantages of the invention will be realized and attained by the structure particularly pointed out in the exemplary embodiments in the written description and claims hereof as well as the appended drawings.

It is to be understood that both the foregoing general description and the following detailed description are exemplary and explanatory and are intended to provide further explanation of the invention as claimed.

### DRAWINGS

Figure 1 is a schematic illustrating a welding-type control system with configurable hardware and input portals in accordance with principles disclosed herein.
Figure 2 is a flow chart illustrating a process for reconfiguring the configurable hardware in accordance with principles disclosed herein.

### DETAILED DESCRIPTION

Various embodiments and aspects of the invention(s) will be described with reference to details discussed below, and the accompanying drawings will illustrate the various embodiments. The following description and drawings are illustrative of the invention(s) and are not to be construed as limiting the invention. Numerous specific details are described to provide a thorough understanding of various embodiments of the present invention(s). However, in certain instances, well-known or conventional details are not de-scribed in order to provide a concise discussion of embodiments of the present invention(s).

In this disclosure, reference is made to Altera Corporation's Quartus® Prime and Quartus® II design tools. These design tools are software applications for designing logic for FPGAs, SoCs, and CPLDs from design entry and synthesis to optimization, verification, and simulation.

A programmer object file (POF) for remote update is a POF that consists of a remote update enabled POF and additional remote update enabled SRAM object files (SOF), and is used to program configuration devices in remote update configuration mode. One creates a remote update enabled POF by adding remote update enabled SRAM object files to a POF in a "Convert Programming Files" dialog box using the Quartus® Prime or Quartus® II application.

A POF for local update is a POF that consists of a local update enabled POF and additional local update enabled SRAM object files, and is used to program configuration devices in a local update configuration mode. One also creates a local update enabled POF by adding local update enabled SRAM object files to a POF in the "Convert Programming Files" dialog box of the Quartus® Prime or Quartus®) II application.

A programmer object file for remote update or programmer object file for local update can be created for Altera® EPC and EPCS devices such as the EPCS1, EPCS4, EPCS16, EPCS64, EPC4, EPC4QC100, EPC8, EPC8QC100, EPC16, EPC16QC100, EPC16UC88, EPCQ128, and EPCQ256 devices using the Quartus® Prime or Quartus® II design tools. FPGAs, can contain only remote update enabled or local update enabled programmer object files and SRAM object files. A programmer object file for remote update or programmer object file for local update created using the Altera Corporation design tools can be used only by supported Altera Corporation device families.

EPCS devices are serial programming interface (SPI) devices with a MISO, MOSI, SS and CLK signal set. The primary purpose of an EPCS device is to configure the FPGA with SRAM configuration data. This translates to downloading a 'hardware' image onto the FPGA on powerup. When the FPGA is powered up, the MSEL pins determine how the FPGA is configured. If the MSEL pins indicate a configuration attempt via an EPCS device, the EPCS device will load the appropriate hardware image if present. An EPCS device is a flash memory device that can store configuration data for FPGA configuration purposes after power on of the a system in which the FPGA is contained.

EPCS are well known and include their own bootloader programs.

A raw programming data file (RPD) (with the extension .rpd) is a file which is generated from a programmer object file (.pof) or JTAG indirect configuration file (.jic) and is always the same size as the Altera EPCS or EPCQ FPGA for which it has been created. The RPD file will contain the configurable hardware configuration data, i.e., the "hardware image."

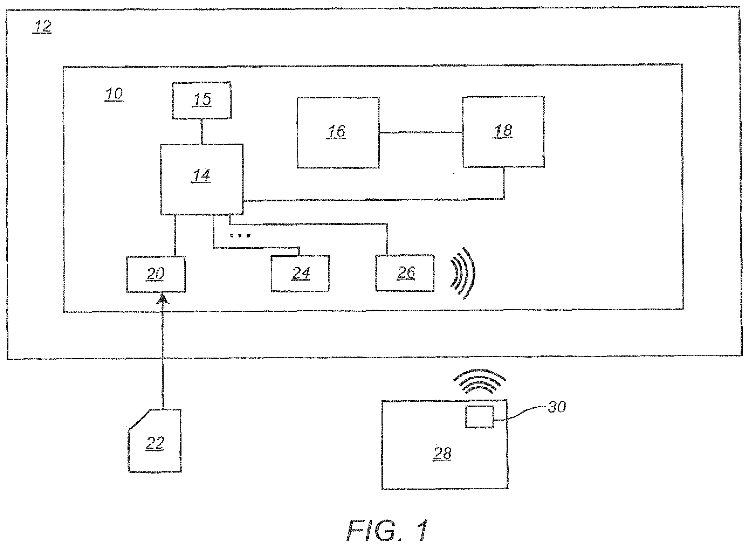

In Figure 1, there is illustrated in block diagram form, a microcontroller board in which the present invention can be employed. The 10 is shown as part of a controlled system 12, e.g., and, preferably, a welding system, a cladding system, or a plasma cutting system.

As illustrated, a controller board 10 includes a processor 14 that controls operation of a system associated 12 with the board 10. The processor is in communication with memory 15 which is representative of one or more memories storing instructions executed by the processor 14 as well as other files used by the processor 14, such as data files, including a transmit buffer described below. The memory 15, thus may constitute one or more different types of memories such as random access memory and read only memory, and buffers.

The board 10 also includes configurable hardware (e.g., an FPGA) 16 and hardware configuration memory device 18 in communication with the processor 14 and the configurable hardware 16 for receipt and loading of configuration data for the configurable hardware 16. The hardware configuration memory device 18 can be, and preferably is an EPCS device which has flash memory for storing a hardware image for the configurable hardware 16.

It should be noted that the flash memory and the configurable hardware can be portions of a same chip, thereby being, e.g., a flash-based FPGA.

The processor 14 is also in communication with a card reader 20. The card reader 20 is configured to accept an memory card 22. Suitable card types include the known card types such as PCMCIA ATA Type I, PCMCIA Type II, PCMCIA Type III, CompactFlash Type I, CompactFlash High-Speed, CompactFlash Type II, Microdrive, MiniCard, SmartMedia, xD-Picture Card, xD-Picture Card Type M, Memory Stick, MagicGate Memory Stick, Memory Stick Select, MagicGate Memory Stick Select, SecureMMC , Secure Digital, Secure Digital High-Speed, Secure Digital Plus, miniSD card, microSD card, SDHC, WiFi SD , U-Flash, C-Flash, SIM (Subscriber Identity Module), Smart card (ISO/IEC 7810, ISO/IEC 7816 card standards, etc.), UFC (USB FlashCard), FISH Universal Transportable Memory Card Standard, Intelligent Stick, (iStick, a USB-based flash memory card with MMS), and SxS.

For the purposes of the present disclosure a Secure Digital card is employed.

For the purposes of providing alternatives as disclosed herein, the processor 14 is also shown in communication with a communications unit 24, which may be any of a serial port, a universal serial bus(USB), FireWire®, Thunderbolt®, HDMI™, an ethernet port, to name a few.

Additionally, for the purposes of providing alternatives as disclosed herein, the processor 14 is shown in communication with a wireless communications unit 26. e.g., a BlueTooth®, Wi-Fi®, or other radio or infrared communications unit. The wireless communications unit 26 is shown in communication with a remote device such as a personal or laptop computer, personal digital assistant, cellular telephone, tablet, and the like which itself has a compatible wireless communications unit 30.

In a preferred embodiment, a non-transitory computer readable storage medium such as a memory card, is used in connection with the card reader 18 to load configuration data into the flash memory 16. Currently, a controller board, such as the Miller Electric Company boards mentioned above, accept a memory card for the updating of software on the board. The processor 14 is programmed to recognize the insertion of a memory card and react accordingly to download the software.

In accordance with principles disclosed herein, the programming that is executed by the processor is adapted to recognize the availability of data for the configuration/reconfiguration of the configurable hardware. If the data is in a file on the memory card, the processor recognizes the type of file and proceeds accordingly. Alternatively, if the data is made available in some other way, for e.g., in a file on a remote storage device, for example, a device sending the file via a BlueTooth® connection, the processor, will recognize the type sending of the file and the type of the file.

In a modification of the foregoing, the processor 14 can be an implemented as part of the configurable hardware 16. Thus, the processor 14 becomes reconfigurable by means of the process described herein. In such case the processor would reside in the configurable hardware 16 and communicate with the various devices 15, 18, 20, 24 and 26 via the configurable hardware 16.

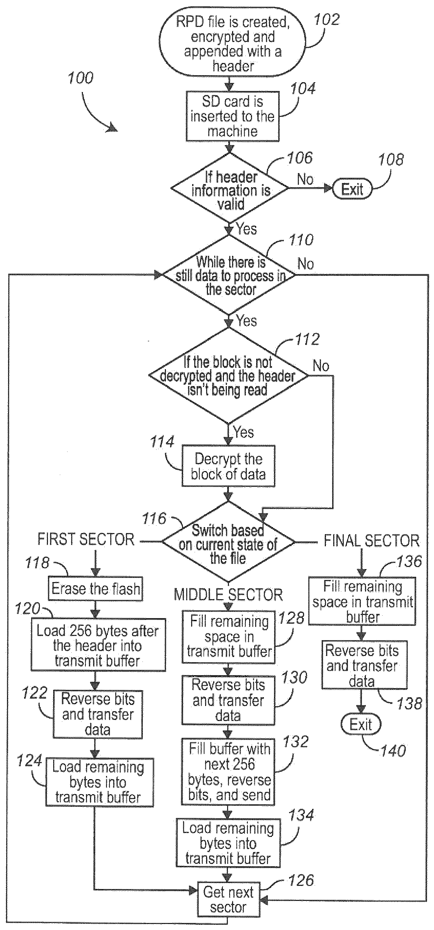

In Figure 2, there is a flow chart that illustrates a process for generating data for updating configurable hardware and for updating or reconfiguring the configurable hardware using the updating data. The process is illustrated as one overall process, although, various portions could be distinct processes.

First, at step 102, a raw programming data file (RPD) is generated using the Quartus Prime or Quartus II application. After a programmer object file (POF) file has been generated using a Quartus® application, it is then converted into the RPD file of RPD data. The RPD data is then encrypted and a header is appended to the top of the file. The header and encrypted RPD data are then stored as a single file, preferably, on a non-transitory computer readable medium, e.g., an SD card.

The header is used to confirm whether the RPD file is a legitimate file and appropriate for the device to which is to be loaded. For example, the header can include the name of the source of the data (e.g., Miller Electric Manufacturing Co.), a software version number, a file name and a product number. The actual information is not limited, but preferably is of a type that can be used to distinguish between suitable and unsuitable data for the system to which it is to be loaded.

As can be appreciated, the RPD data is saved in 512 byte-sized blocks, i.e., the RPD file contains the header, and then a number of 512 byte-sized data blocks thereafter. Thus, the presence of a header in the file creates the undesired effect of causing a constant offset in the data. In the present implementation, the first sector in the RPD file contains the header, which is around 200 bytes. Thus the first sector of the RPD file only contains about 312 bytes of data, and the remainder of the first block of data appears in the second sector. Then part of the data for the second block similar appears in the second and third file sectors. This offset continues until the end of the file.

At step 104, the SD card can then be or is inserted into the machine with the configurable hardware for an update. Preferably, the machine is a welding, cladding or plasma cutting machine.

At step 106, the header added to the RPD is extracted from the first sector of the file by the processor 14 to determine whether or not the file is valid. Thus, the processor 14 is programmed to compare information in the header with like or similar information stored in the memory 15. If the information in the header is acceptable, the file is validated.

Once the file is confirmed to be valid, the writing process then begins. If the header does not validate, the process is ended and the loading processes is exited as indicated at step 108.

However, if the header validates, then the loading process proceeds to step 110 where it is determined if there is data to be processed, i.e., whether there is data in the current RPD file sector under consideration to be loaded into the flash memory of the EPCS device. If there is data to be loaded, the process proceeds to step 112 where it is determined whether the data is decrypted and whether the header has just been read. If the data is not decrypted, i.e., it is still encrypted, or if the header has just been read, the process proceeds to step 114. Otherwise the process proceeds to step 126, described below, to select the next sector.

It can be appreciated that the determination as to whether a header has just been read is relevant only to the processing of the first sector of the RPD file. Thereafter, the result of the query as to whether the header is being read (has just been read) will be negative.

At step 114, the data of the sector under consideration is decrypted. That is, when the first sector of the RPD file is under consideration, the RPD data in the first sector is decrypted. Because of the header in the first sector, this will be about 312 bytes of data. For the following, middle sectors it will be 512 bytes of data. For the last sector, the amount can be 512 or less. Then the process proceeds to step 116.

At step 116, a determination is made as to which sector is under consideration, i.e., whether it constitutes the first sector to be read, the last sector to be read, or a middle sector in between the first and last sectors. If it is the first sector, the process proceeds to step 118.

At step 118, the flash memory in the hardware configuration memory device 18 is erased by setting all its bits to logic level one. After the flash memory is erased it can be written to. Then the process proceeds to step 120, where 256 bytes following the header are loaded into a transmit buffer.

As mentioned above, the data or RPD file on the SD card is in 512 byte sectors. However, the flash memory can be page bound to a smaller size. For example, on an Altera® EPCS device to which the data is being written is page bound with a size of 256 bytes. Although, other devices may not have flash memory so page bound, for the purposes of this disclosure the page limit is considered.

Once the data has been loaded into the transmit buffer, the process proceeds to step 122.

At step 122, the order of the bits of each byte of data preferably is reversed. In that regard, an EPCS flash memory requires that bytes of data be written to it in reverse significant bit order, namely with the least significant bit of each byte written first. Because the present disclosure is being made in the context of the Altera® configurable hardware, for the purposes of this disclosure such a requirement is assumed.

While the bits could be reversed during reading, this pre-loading reversal makes the process simpler and more efficient. Thereafter, the process proceeds to step 124.

Then the data in the transmit buffer is loaded or transmitted to the EPCS flash memory.

At step 124, the remaining data in the first sector are loaded into the transmit buffer. As can be appreciated, a header of size 200 bytes, with the prior loading and transmitted of 256 bytes of data, the remaining data should be 312-256=56 bytes of data. Since the 56 bytes of data does not fill the 256 byte transmit buffer, it remains queued and unreversed in the transmit buffer the loading process proceeds to step 126 to select the next sector of data from the RPD file. From step 126, the process returns to step 110.

For the middle sectors, there will be no header read, and the data will be encrypted so step 114 will be performed for each of them. Further, since the middle sectors are neither the first nor the last sector, after step 116, the process will proceed to step 128.

At step 128, the remainder of the transmit buffer is filled. Using the second sector as an example, a data block in the amount of the size of the header (e.g., 200 bytes) will fill the remainder of the transmit buffer. Thereafter, at step 130, the bits in the transmit buffer are reversed and the data is transmitted to the EPCS.

At step 132, the transmit buffer is again filled with 256 bits of data. These bits are then reversed and transmitted to the EPCS.

At step 134 the remaining data in the middle sector, which should again be 56 bytes are loaded into the transmit buffer and left queued but not reversed. Then the process proceeds to step 126 to return to step 110 where the next sector to be processed is selected.

The foregoing steps are performed for the second to second-to-last sectors, i.e., until at step 116 it is determined that the last sector in the RPD file is being processed. When the last sector is being processed, the process proceeds to step 136.

At step 136, the remaining data, for example of 200 bytes (for a 200 byte header), is loaded into the transmit buffer to join the queued 56 bytes of data. Then at step 138 the bits are reversed and the data is uploaded to the EPCS flash memory.

After the last sector is processed, at step 140 the process is exited.

Once the data in the RPD file has been transferred to the EPCS, the power to the board can be turned off and the memory card removed. On the next power up of the board, the EPCS flash memory will communicate with the FPGA and program the FPGA RPD data. The manner in which the data is loaded is specified by the Altera company design.

While an embodiment using a memory card to load files has been described, the process would be similar for remotely stored files, such as RPD files transmitted using wireless or wired communications. The protocols for transmitting such files are well known and not detailed herein.

However, it can be appreciated, that using such protocols, the processor 14 can receive an RPD file and temporarily store in in the memory 15, and then proceed in accordance with the steps outlined above to extract the hardware image and store same in the hardware configuration memory device 18.

The embodiments described above are intended to be exemplary. One skilled in the art recognizes that numerous alternative components and embodiments that may be substituted for or included in the particular examples described herein and such additions or substitutions still fall within the scope of the invention(s).

## Claims

1. A welding-type control system comprising;
- configurable hardware;
- a hardware configuration memory device that configures the configurable hardware when loaded with configuration data; a processor;
- an input portal via which the processor can receive a file with the configuration data; and
- memory including instructions that when executed by the processor cause the processor to transfer the configuration data in the file to the memory device.

2. The welding-type control system of claim 1,
wherein the instructions cause the processor to validate the file by reading information in a header in the file and comparing the information to validating information.

3. The welding-type control system of claim 1 or 2,
wherein the instructions cause the processor to transfer the configuration data to the hardware configuration memory device.

4. The welding-type control system of one of the preceding claims,
wherein the instructions cause the processor to reverse the order of the bits in each byte of configuration data to be in reverse significant bit order prior to transfer of the configuration data to the hardware configuration memory device.

5. The welding-type control system of one of the preceding claims,
wherein the input portal is a card reader for a memory card.

6. The welding-type control system of one of the preceding claims,
wherein the input portal is one of a memory card reader, a serial or parallel interface, or a wireless communications system.

7. The welding-type control system of one of the preceding claims,
wherein the configurable hardware is a field programmable gate array.

8. The welding-type control system of one of the preceding claims,
wherein the configurable hardware is a field programmable gate array, a complex programmable logic device, a simple programmable logic device, or a system on a chip.

9. The welding-type control system of one of the preceding claims,
wherein the hardware configuration memory device comprises flash memory.

10. A non transitory computer readable medium that includes program instructions that when executed by a welding-type system processor, cause the processor to:
(a) read a header in a raw programming data file to validate the raw programming data file;
(b) extract raw programming data from the raw programming data file;
and
(c) transmit the raw programming data to a hardware configuration memory device.

11. The non-transitory computer readable medium of claim 10,
wherein the program instructions, when executed by the processor, cause
the processor to format each byte of the raw programming data prior to transmitting the raw programming data to the hardware configuration memory device by ordering the bits of the byte in reverse significant bit order.

12. The non-transitory computer readable medium of claim 10 or 11,
wherein, the program instructions, when executed by the processor, cause
the processor to use a 256 byte transmit buffer to transmit 512 byte serial sectors of raw programming data in incremental blocks, taking into account an offset in the raw programming data in the raw programming data file caused by the presence of the header.
